(19) Europäisches Patentamt
European Patent Office
Office européen des brevets

(11) **EP 2 625 857 B1**

(12) **EUROPEAN PATENT SPECIFICATION**

(45) Date of publication and mention of the grant of the patent:
**10.04.2019 Bulletin 2019/15**

(21) Application number: **11802799.4**

(22) Date of filing: **01.11.2011**

(51) Int Cl.:
*H04N 19/635* (2014.01)     *H04N 19/122* (2014.01)
*H03M 7/30* (2006.01)

(86) International application number:
**PCT/IL2011/000847**

(87) International publication number:
**WO 2012/046242 (12.04.2012 Gazette 2012/15)**

(54) **MODIFIED GABOR TRANSFORM WITH GAUSSIAN COMPRESSION AND BI-ORTHOGONAL DIRICHLET GAUSSIAN DECOMPRESSION**

MODIFIZIERTE GABOR-TRANSFORMATION MIT GAUSSSCHER KOMPRESSION UND BI-ORTHOGONALER GAUSSCHER DIRICHLET-DEKOMPRESSION

TRANSFORMATION DE GABOR MODIFIÉE À COMPRESSION GAUSSIENNE ET DÉCOMPRESSION DIRICHLET GAUSSIENNE BI-ORTHOGONALE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.10.2010 US 390228 P**

(43) Date of publication of application:
**14.08.2013 Bulletin 2013/33**

(73) Proprietor: **Yeda Research and Development Co. Ltd.**
**7610002 Rehovot (IL)**

(72) Inventors:
• **TANNOR, David J.**
**76225 Rehovot (IL)**
• **SHIMSHOVITZ, Asaf**
**76100 Rehovot (IL)**

(74) Representative: **Pearl Cohen Zedek Latzer Baratz UK LLP**
**16 Upper Woburn Place**
**London WC1H 0BS (GB)**

(56) References cited:
• **TOURADJ EBRAHIMI ET AL: "IMAGE COMPRESSION BY GABOR EXPANSION", OPTICAL ENGINEERING, SOC. OF PHOTO-OPTICAL INSTRUMENTATION ENGINEERS, BELLINGHAM, vol. 30, no. 7, 1 July 1991 (1991-07-01), pages 873-880, XP000217387, ISSN: 0091-3286**
• **SHIDONG LI ED - INSTITUTE OF ELECTRICAL AND ELECTRONICS ENGINEERS: "A generalized non-separable 2-D discrete Gabor expansion for image representation and compression", PROCEEDINGS OF THE INTERNATIONAL CONFERENCE ON IMAGE PROCESSING (ICIP) AUSTIN, NOV. 13 - 16, 1994; [PROCEEDINGS OF THE INTERNATIONAL CONFERENCE ON IMAGE PROCESSING (ICIP)], LOS ALAMITOS, IEEE COMP. SOC. PRESS, US, vol. 1, 13 November 1994 (1994-11-13), pages 810-814, XP010146012, DOI: 10.1109/ICIP.1994.413427 ISBN: 978-0-8186-6952-1**
• **GOURONC J-L ET AL: "A near optimal algorithm for image compression using Gabor expansion", PROCEEDINGS OF THE INTERNATIONAL SYMPOSIUM ON CIRCUITS AND SYSTEMS. (ISCS). CHICAGO, MAY 3 - 6, 1993; [PROCEEDINGS OF THE INTERNATIONAL SYMPOSIUM ON CIRCUITS AND SYSTEMS. (ISCS)], NEW YORK, IEEE, US, vol. -, 3 May 1993 (1993-05-03), pages 251-254, XP010115150, DOI: 10.1109/ISCAS.1993.393705 ISBN: 978-0-7803-1281-4**

- **YAO J: "COMPLETE GABOR TRANSFORMATION FOR SIGNAL REPRESENTATION", IEEE TRANSACTIONS ON IMAGE PROCESSING, IEEE SERVICE CENTER, PISCATAWAY, NJ, US, vol. 2, no. 2, 1 April 1993 (1993-04-01), pages 152-159, XP000380855, ISSN: 1057-7149, DOI: 10.1109/83.217220**
- **WANG H ET AL: "EFFICIENT IMPLEMENTATION OF GABOR TRANSFORMS FOR IMAGE COMPRESSION", ELECTRONICS LETTERS, IEE STEVENAGE, GB, vol. 28, no. 9, 23 April 1992 (1992-04-23) , pages 870-871, XP000296686, ISSN: 0013-5194**
- **HANG WANG ET AL: "EFFICIENT IMAGE CODING METHOD BASED ON ADAPTIVE GABOR DISCRETE COSINE TRANSFORMS", JOURNAL OF ELECTRONIC IMAGING, SPIE / IS & T, 1000 20TH ST. BELLINGHAM WA 98225-6705 USA, vol. 2, no. 1, 1 January 1993 (1993-01-01) , pages 38-43, XP000355270, ISSN: 1017-9909, DOI: 10.1117/12.134251**

**Description**

FIELD OF THE INVENTION

The field of the present invention is signal processing. More specifically, the present invention relates to signal compression, image compression.

BACKGROUND OF THE INVENTION

Many conventional signal processing techniques represent signals in terms of basis functions, such as the familiar Fourier transform. Ideally, a good choice of basis functions should provide accuracy and efficiency - accuracy in providing reliable results, and efficiency in requiring only a relatively small number of basis functions. However, global basis functions, such as sinusoidals, that yield global accuracy generally suffer from inefficiency, and local basis functions that yield efficiency generally lack global accuracy.

One of the main conventional tools used in communication theory and data storage dates back to a seminal paper by Gabor in 1946. Gabor observed that storing data in a time-based representation is inefficient since all frequencies are stored at each time, and storing information in a frequency-based representation is also inefficient since each frequency contains all times. Gabor suggested use of a basis of Gaussian functions that are localized in both time and frequency, which enables one in principle to reduce storage by saving only certain frequencies at certain times. Gabor reasoned that the set of coefficients required to represent a signal in the Gabor basis should be sparse. However, a drawback of Gabor's approach is the complexity of calculating these coefficients, due to the non-orthogonality of the Gabor basis. Subsequent work, many years after Gabor, provided a precise theory for calculating the coefficients, but another drawback emerged; namely, the representation of a generic signal in the Gabor basis is highly inaccurate unless a much larger density of Gaussians is used than as originally proposed by Gabor -- significantly compromising the sparseness that Gabor envisioned.

It would thus be of advantage to find a variant of the Gabor transform in which the sparse representation that Gabor envisioned is achieved. Moreover, it would further be of advantage if the coefficients required to represent a signal would be as convenient to calculate as simple overlaps of the signal with the Gabor basis functions.

Many years after Gabor, the concept of the wavelet basis was introduced. To a large extent, the wavelet basis is an extension of the Gabor basis that allows for unequal spacing and widths of the Gaussians, or such other functions, and that satisfies a general scaling relationship. Straightforward implementation of a wavelet basis of Gaussians suffers from the same drawbacks as Gabor theory; namely, the difficulty in calculating the coefficients and the requirement of an anomalously high density of basis functions. It would thus be of advantage to have a variant of wavelet theory in which the expected degree of sparseness is realized, and in which the coefficients required to represent a signal would be as convenient to calculate as simple overlaps of the signal with the Gaussians.

TOURADJ EBRAHIMI et al: "Image Compression by Gabor expansion", OPTICAL ENGINEERING, SOC. OF PHOTO-OPTICAL INSTRUMENTATION ENGINEERS, BELLINGHAM, vol. 30, no. 7, 1 July 1991 (1991-07-01), pages 873-880, ISSN: 0091-3286 describes application of a Gabor decomposition to image compression, and a method, based on least-mean-squares error, for extracting the weighting factors of the decomposition.

SHIDONG LI ED - INSTITUTE OF ELECTRICAL AND ELECTRONICS ENGINEERS: "A generalized non-separable 2-D discrete Gabor expansion for image representation and compression", PROCEEDINGS OF THE INTERNATIONAL CONFERENCE ON IMAGE PROCESSING (ICIP) AUSTIN, NOV. 13 - 16, 1994; [PROCEEDINGS OF THE INTERNATIONAL CONFERENCE ON IMAGE PROCESSING (ICIP)], LOS ALAMITOS, IEEE COMP. SOC. PRESS, US, vol. 1, 13 November 1994 (1994-11-13), pages 810-814, DOI: 10.1109/ICIP.1994.413427 ISBN: 978-0-8186-6952-1 describes a general mathematical framework, referred to as "pseudo frame decompositions", for analyzing discrete Gabor expansions, and for using non-separable 2-D Gabor expansions to achieve a desired orientation of the Gabor functions.

GOURONC J-L ET AL: "A near optimal algorithm for image compression using Gabor expansion", PROCEEDINGS OF THE INTERNATIONAL SYMPOSIUM ON CIRCUITS AND SYSTEMS. (ISCS). CHICAGO, MAY 3 - 6, 1993; [PROCEEDINGS OF THE INTERNATIONAL SYMPOSIUM ON CIRCUITS AND SYSTEMS. (ISCS)], NEW YORK, IEEE, US, vol. -, 3 May 1993 (1993-05-03), pages 251-254, DOI: 10.1109/ISCAS. 1993.393705 ISBN: 978-0-7803-1281-4 describes an iterative conjugate gradient algorithm for finding coefficients of complete and partial Gabor expansions, with application to digital image compression.

YAO J: "COMPLETE GABOR TRANSFORMATION FOR SIGNAL REPRESENTATION", IEEE TRANSACTIONS ON IMAGE PROCESSING, IEEE SERVICE CENTER, PISCATAWAY, NJ, US, vol. 2, no. 2, 1 April 1993 (1993-04-01), pages 152-159, ISSN: 1057-7149, DOI: 10.1109/83.217220 describes a fast discrete Gabor transform method, and its relationship to the analytical form of the transform in terms of bi-orthogonal functions.

SUMMARY OF THE DESCRIPTION

Aspects of the present invention relate to a modified Gabor transform in which a signal is represented in terms of coefficients that are calculated by overlapping the signal with a set of Gaussian basis functions. The coefficients are used to compress the signal, and the basis functions, in a modified form as described below, are used to reconstruct the signal by decompression.

In one embodiment of the present invention, referred to herein as the G-transform, the overlaps are computed with the Gabor basis functions. In another embodiment of the present invention, referred to herein as the w-transform, the overlaps are computed with a wavelet basis of Gaussians; i.e., Gaussians that are shifted and scaled in width. The overlaps determine the coefficients that provide the compressed representation of the signal.

As such, the coefficients are simple to calculate, being just the overlap of the signal with a discrete set of Gaussians. As a result, compression is performed very fast, which is an important feature for applications that require real-time compression.

For reconstructing a signal, the underlying basis functions used in calculating the coefficients must be known. In one embodiment of the present invention, corresponding to the G-transform, the basis functions are bi-orthogonal to Gaussian functions that have been convoluted with Dirichlet (i.e., periodic sinc) functions. These basis functions define the inverse G-transform. In another embodiment of the present invention, corresponding to the w-transform, the basis functions are bi-orthogonal to wavelets of Gaussian functions that have been convoluted with Dirichlet functions. These basis functions define the inverse w-transform. The convolution of the basis functions with Dirichlet functions guarantees equivalence to the Fourier transform vis-à-vis accuracy and stability. The need for an anomalously high density of Gaussians in the basis is thus eliminated.

As such, the G-transform / w-transform of the present invention combines the simplicity and sparseness of computing overlaps of a discrete set of Gaussians with a signal, providing fast compression. The inverse G-transform / inverse w-transform reconstructs the original signal, with accuracy and stability equivalent to that of the Fourier transform without requiring an anomalously high density of Gaussians in the basis.

The modified Gabor transform of the present invention has proven to be of significant advantage for signal compression.

There is thus provided in accordance with an embodiment of the present invention a signal processor for compressing signal data, including a function shapes generator for receiving as input time and frequency scale parameters, and for generating as output a plurality of shape parameters for a corresponding plurality of localized functions, wherein the shape parameters govern the centers and spreads of the localized functions, a matrix generator, coupled with the function shapes generator, for receiving as input the plurality of shape parameters generated by the function shapes generator, and a sequence of sampling times, and for generating as output a matrix whose elements are the values of the localized functions at the sampling times, wherein each column of the matrix corresponds to one of the localized functions, and wherein each row of the matrix corresponds to one of the sampling times, and wherein the matrix has a conjugate transpose matrix; a signal transformer, coupled with the matrix generator, for receiving as input an original signal, and the matrix generated by the matrix generator, and for generating as output a transformed signal by applying the conjugate transpose matrix to the original signal, and a signal compressor, coupled with the signal transformer, for receiving as input the transformed signal generated by the signal transformer, and for generating as output a compressed representation of the transformed signal.

There is additionally provided in accordance with an embodiment of the present invention a signal processor for decompressing compressed signal data, including a function shapes generator for receiving as input time and frequency scale parameters, and for generating as output a plurality of shape parameters for a corresponding plurality of localized functions, wherein the shape parameters govern the centers and spreads of the localized functions, a matrix generator, coupled with the function shapes generator, for receiving as input the plurality of shape parameters generated by the function shapes generator, and a sequence of sampling times, and for generating as output a matrix whose elements are the values of the plurality of localized functions at the sampling times, wherein each column of the matrix corresponds to one of the localized functions, and wherein each row of the matrix corresponds to one of the sampling times, a matrix inverter, coupled with the matrix generator, for inverting the conjugate transpose matrix for the matrix generated by the matrix generator, a signal decompressor for receiving as input a compressed representation of a signal, and for generating as output a decompressed signal, and a signal transformer, coupled with the signal decompressor and with the matrix inverter, for receiving as input the decompressed signal generated by the signal decompressor, and the inverse conjugate transpose matrix generated by the matrix inverter, and for generating as output a reconstructed signal corresponding to the result of applying the inverse conjugate transpose matrix to the decompressed signal.

There is yet further described in the following a digital image processor for compressing a digital image, including a function shapes generator for receiving as input spatial and frequency scale parameters, and for generating as output a plurality of shape parameters for a corresponding plurality of localized functions, wherein the shape parameters govern the centers and spreads of the localized functions, a matrices generator, coupled with the function shapes generator, for receiving as input the plurality of shape parameters generated by the function shapes generator, and first and second sequences of spatial sampling points, and for generating as output (i) a first matrix whose elements are the values of the localized functions at the first sequence of spatial sampling points, wherein each column of the first matrix corresponds to one of the localized functions, and wherein each row of the first matrix corresponds to one of the spatial sampling points from the first sequence, and (ii) a second matrix whose elements are the values of the localized functions at the second sequence of spatial sampling points, wherein each column of the second matrix corresponds to one of the localized functions, and wherein each row of the second matrix corresponds to one of spatial sampling points from the second sequence, an image transformer, coupled with the matrices generator, for receiving as input an original digital image, and the first and second matrices generated by the matrices generator, and for generating as output a transformed image by applying the conjugate transpose matrices to the original digital image, and an image compressor, coupled with the image transformer, for receiving as input the transformed image generated by the image transformer, and for generating as output a compressed representation of the transformed image.

There is moreover described in the following a digital image processor for decompressing compressed digital image data, including a function shapes generator for receiving as input spatial and frequency scale parameters, and for generating as output a plurality of shape parameters for a corresponding plurality of localized functions, wherein the shape parameters govern the centers and spreads of the localized functions, a matrices generator, coupled with the function shapes generator, for receiving as input the plurality of shape parameters generated by the function shapes generator, and first and second sequences of spatial sampling points, and for generating as output (i) a first matrix whose elements are the values of the plurality of localized functions at the first sequence of spatial sampling points, wherein each column of the first matrix corresponds to one of the localized functions, and wherein each row of the first matrix corresponds to one of the spatial sampling points from the first sequence, and (ii) a second matrix whose elements are the values of the plurality of localized functions at the second sequence of spatial sampling points, wherein each column of the second matrix corresponds to one of the localized functions, and wherein each row of the second matrix corresponds to one of the spatial sampling points from the second sequence, a matrices inverter, coupled with the matrices generator, for inverting the conjugate transposes of the first and second matrices generated by said matrices generator, a digital image decompressor for receiving as input a compressed representation of a digital image, and for generating as output a decompressed digital image, and a digital image transformer, coupled with the digital image decompressor and with the matrices inverter, for receiving as input the decompressed digital image generated by the signal decompressor, and the inverse conjugate transpose matrices generated by the matrices inverter, and for generating as output a reconstructed digital image corresponding to the result of applying the inverse conjugate transpose matrices to the decompressed digital image.

The following definitions are employed throughout the specification and claims.

A-TRANSFORM -- the representation of a signal in terms of the overlaps of an arbitrary basis of linearly independent compactly supported functions with the signal.

GABOR BASIS -- a basis of time-frequency Gaussians centered on a discrete lattice in phase space with cells of area 2n in time-frequency phase space, and cells of area h (Planck's constant) in position-momentum phase space.

GABOR TRANSFORM -- the representation of a signal in terms of its coefficients with respect to the Gabor basis.

G-TRANSFORM -- the representation of a signal in terms of the overlaps of the Gabor basis functions with the signal.

INVERSE A-TRANSFORM - the operation that reconstructs an original signal from the a-transform of the signal.

INVERSE GABOR TRANSFORM -- the operation that reconstructs an original signal from the Gabor transform of the signal.

INVERSE G-TRANSFORM -- the operation that reconstructs an original signal from the G-transform of the signal.

INVERSE WAVELET TRANSFORM -- the operation that reconstructs an original signal from the wavelet transform of the signal.

INVERSE W-TRANSFORM - the operation that reconstructs an original signal from the w-transform of the signal.

MODIFIED GABOR TRANSFORM - a term referring collectively to the G-transform, the inverse G-transform, the w-transform, the inverse w-transform, the a-transform and the inverse a-transform.

PHASE SPACE -- the two-dimensional space of time-frequency parameters in signal processing, and of position-momentum parameters in quantum mechanics.

WAVELET BASIS -- a basis of time-frequency Gaussians centered on a discrete lattice in phase space whose centers and widths satisfy a recursive scaling relationship.

WAVELET TRANSFORM -- the representation of a signal in terms of its coefficients in the wavelet basis.

W-TRANSFORM -- the representation of a signal in terms of the overlaps of the wavelet basis functions with the signal.

BRIEF DESCRIPTION OF THE DRAWINGS

The present invention will be more fully understood and appreciated from the following detailed description, taken in conjunction with the drawings in which:

**FIG. 1** is a simplified block diagram of a system for constructing a Gabor matrix, G, and a basis matrix, F, which are used for compressing and decompressing a digital signal, in accordance with an embodiment of the present invention;
**FIG. 2** is a simplified diagram of a uniform geometry for locations of centers of Gaussian functions, in accordance with an embodiment of the present invention;
**FIG. 3** is a simplified diagram of a non-uniform geometry for locations of centers of Gaussian functions, in accordance with an embodiment of the present invention;
**FIG. 4** is a simplified block diagram of a signal compressor, using a Gabor matrix, in accordance with an embodiment of the present invention;
**FIG. 5** is a simplified block diagram of a signal decompressor, using a basis matrix, in accordance with an embodiment of the present invention;
**FIG. 6** is two plots of error between an original signal and the reconstructed signal, for a sample simulation, based on the signal compressor and decompressor shown in **FIGS. 4** and **5;**
**FIG. 7** is a simplified block diagram of a system for constructing Gabor matrices, G1 and G2, and basis matrices, F1 and F2, which are used for compressing and decompressing a digital image, in accordance with an embodiment of the present invention;
**FIG. 8** is a simplified block diagram of a digital image compressor, using two Gabor matrices, in accordance with an embodiment of the present invention;
**FIG. 9** is a simplified block diagram of a digital image decompressor, using two basis matrices, in accordance with an embodiment of the present invention;

<u>LIST OF APPENDICES</u>

**Appendix A** is a detailed listing of computer source code written in the Matlab programming language for audio compression using a Gabor matrix, in accordance with an embodiment of the present invention;

<u>DETAILED DESCRIPTION</u>

Aspects of the present invention relate to a novel transform in which a signal is represented in terms of coefficients that are calculated by overlapping the signal with a set of Gaussian basis functions. The coefficients are used to compress the signal, and the basis functions, in a modified form as described below, are used to reconstruct the signal by decompression.
In one embodiment of the present invention, referred to herein as the G-transform, the overlaps are computed with the Gabor basis functions. In another embodiment of the present invention, referred to herein as the w-transform, the overlaps are computed with a wavelet basis of Gaussians; i.e., Gaussians that are shifted and scaled in width. The overlaps determine the coefficients that provide the compressed representation of the signal.
As such, the coefficients are simple to calculate, being just the overlap of the signal with a discrete set of Gaussians. As a result, compression is performed very fast, which is an important feature for applications that require real-time compression.
For reconstructing a signal, the underlying basis functions used in calculating the coefficients must be known. In one embodiment of the present invention, corresponding to the G-transform, the basis functions are bi-orthogonal to Gaussian functions that have been convoluted with Dirichlet (i.e., periodic sinc) functions. These basis functions define the inverse G-transform. In another embodiment of the present invention, corresponding to the w-transform, the basis functions are bi-orthogonal to wavelets of Gaussian functions that have been convoluted with Dirichlet functions. These basis functions define the inverse w-transform.
The novel transform of the present invention has proven to be of significant advantage for signal compression.

**Application of the Invention to Signal Compression**

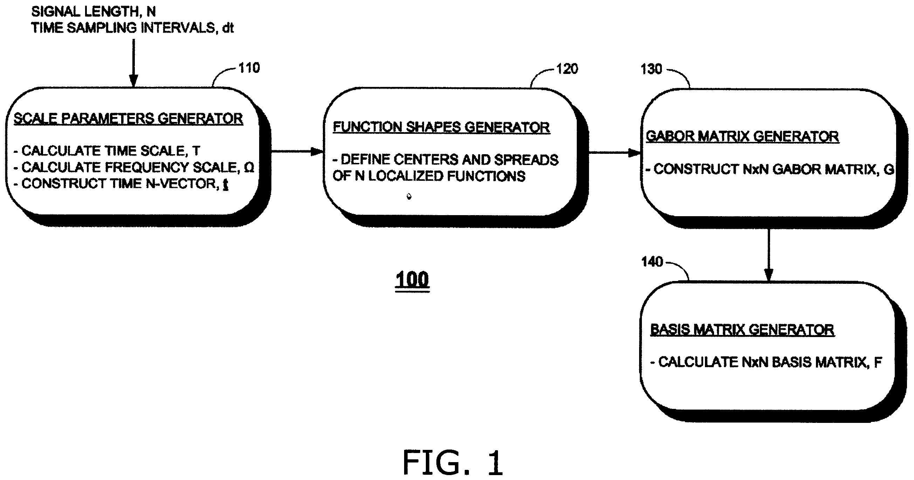

The present invention has been found to be of significant advantage for signal compression, including inter alia audio compression, and for image compression. In one embodiment of the present invention, described hereinbelow, a modified Gabor transform is used with Gaussian functions for compressing a signal, and is used with the bi-orthogonal Dirichlet Gaussian basis functions for decompressing the compressed signal.
Reference is made to **FIG. 1**, which is a simplified block diagram of a system **100** for constructing a Gabor matrix, G, and a basis matrix, F, which are used for compressing and decompressing a digital signal, in accordance with an embodiment of the present invention. The system in **FIG. 1** includes four components; namely, a scale parameters generator **110,** a function shapes generator **120,** a Gabor matrix generator **130,** and a basis matrix generator **140.**

Scale parameters generator **110** receives as input (i.1) a signal length, N, and (i.2) a sampling time interval, dt; and generates as output (o.1) a time scale, T, (o.2) a frequency scale, $\Omega$, and (o.3) a time N-vector $\underline{t} = (t_n: n = 0, ..., N-1)$. In one embodiment of the present invention, the outputs of scale parameters generator **110** are generated according to the following equations.

$$T = N * dt \qquad\qquad (1)$$

$$\Omega = \pi / dt \qquad\qquad (2)$$

$$t_n = n\, dt, \text{ for } n = 0, ..., N-1 \qquad\qquad (3)$$

Function shapes generator **120** receives as input (i.1) a signal length parameter N, (i.2) a time scale parameter T, such as the parameter given by **Equation (1)** above, and (i.3) a frequency scale parameter $\Omega$, such as the parameter given by **Equation (2)** above; and generates as output (o.1) centers, $(t_{Cn}, \omega_{Cn})$, for n = 0, ..., N-1, and (o.2) a spread, a. In one embodiment of the present invention, the outputs of function shapes generator **120** are generated according to the following method.

Begin with a rectangle, R, with sides [0, T] and [$-\Omega$, $\Omega$], and sub-divide R into small N uniform rectangles, each of area 2$\pi$. Define $(t_{Cn}, \omega_{Cn})$ to be the centers of the small rectangles; n = 0, ..., N-1. The spread, a, is defined according to the following equation.

$$a = \Delta\Omega / (2\, \Delta T) , \qquad\qquad (4)$$

where $\Delta T$ and $\Delta\Omega$ are the dimensions of the small rectangles. The centers $(t_{Cn}, \omega_{Cn})$ and the spread $\alpha$ control the shapes of the Gaussian functions given by **Equation (6)** below.

Gabor matrix generator **130** receives as input (i.1) a time N-vector $\underline{t} = (t_n: n = 0, ..., N-1)$, such as the vector given by **Equation (3)** above, (i.2) N centers $(t_{Cn}, \omega_{Cn})$, such as the centers defined above, and (i.3) a spread a, such as the spread given by **Equation (4)** above; and generates as output (o.1) an NxN Gabor matrix, G = $(g_{mn})$. In one embodiment of the present invention, the output of Gabor matrix generator **130** is generated according to the following equation.

$$g_{mn} = g(t_m - t_{Cn}, \omega_{Cn}; a) \qquad\qquad (5)$$

for m = 0, ..., N-1 and n = 0, ..., N-1. In one embodiment of the present invention, $g(t, \omega; \alpha)$ is a periodic function of t of period T, given in the interval [0, T] by the complex-valued Gaussian function

$$g(t, \omega; a) = \left(\frac{2\alpha}{\pi}\right)^{\frac{1}{4}} \exp(-\alpha t^2 + i\omega t) , \; 0 \le t < T , \qquad\qquad (6)$$

The periodicity of $g(t, \omega; \alpha)$ is convenient for efficient construction of the Gabor matrix, G, as described hereinbelow with reference to **Equation (8).**

The function $g(t, \omega; \alpha)$ is substantially localized, and the spread, a, controls the degree of localization. It will be appreciated by those skilled in the art that other choices of the function $g(t, \omega; \alpha)$ may be used to advantage in the present invention; in particular, wavelet functions, which are also substantially localized.

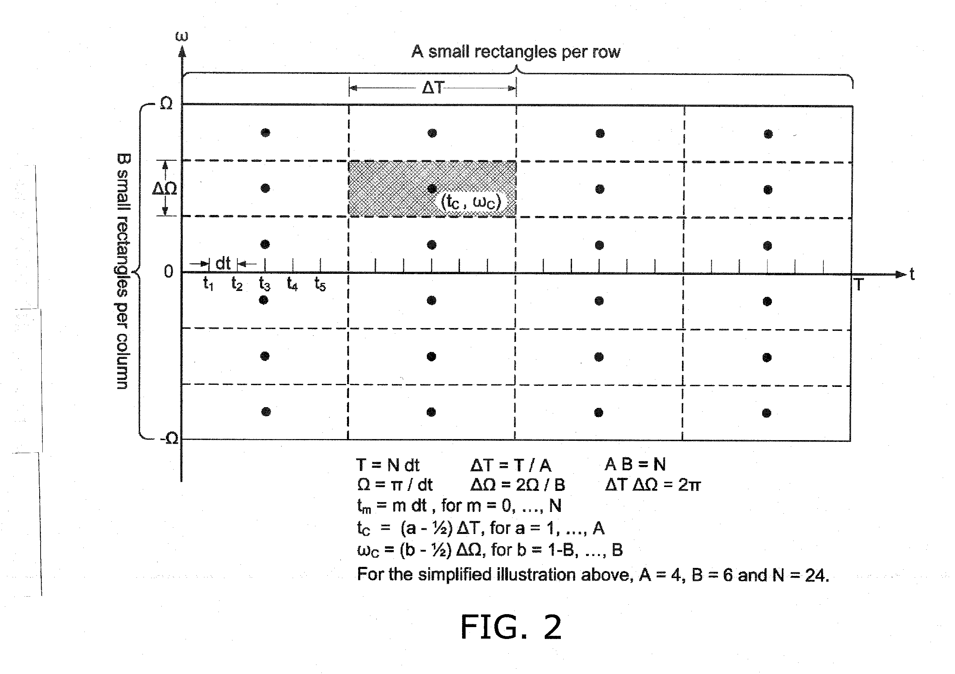

For the choice of the Gaussian function given by **Equation (6),** the computation of the matrix elements $g_{mn}$ given by **Equation (5)** may be accelerated by avoiding redundant computations. Reference is made to **FIG. 2,** which is a simplified diagram of a uniform geometry for locations of centers of Gaussian functions, in accordance with an embodiment of the present invention. A typical small rectangle of dimensions $\Delta T$ x $\Delta\Omega$ is shown cross-hatched in **FIG. 2,** with its center indicated by a small black circle.

According to **Equation (5)** above, each column of the matrix G includes terms with $g(t, \omega_{Cn}; a)$ evaluated at N different times $t_m - t_{Cn}$ for m = 0, ..., N-1, for a fixed center $(t_{Cn}, \omega_{Cn})$. Therefore, because of the periodicity of $g(t, \omega; \alpha)$ in t, if one column, say the $j^{th}$ column of G has been computed, then the other columns may be derived therefrom by use of the relationship

$$g(t, \mu; a) = \exp[i(\mu - \omega)t]\, g(t, \omega; a) \qquad (7)$$

and observing that each argument $t_m - t_{Cn}$ for m = 0, ..., N-1 and n = 1, ..., N, is equal to $(t_k - t_{Cj})$ or $(t_k - t_{Cj}) + N$ or $(t_k - t_{Cj}) - N$, for some k = 1, ..., N. Specifically, if $t_{Cn} - t_{Cj} = a\,\Delta T$ for some a = 1-A, ..., A-1, and if $\omega_{Cn} - \omega_{Cj} = b\,\Delta\Omega$ for some b = 1-B, ..., B-1, then

$$g_{mn} = \exp\left(2m\pi i\, \frac{b}{B}\right) \begin{cases} g_{m-Ba\ j}, & 0 \le m - Ba < N \\ g_{m-Ba+N\ j}, & -N \le m - Ba < 0 \\ g_{m-Ba-N\ j}, & N \le m - Ba < 2N \end{cases} \qquad (8)$$

I.e., the $n^{th}$ column of G is a cyclic shift of the $j^{th}$ column of G with shift amount Ba, and with entries multiplied by the complex exponential factors exp(2mni b/B), m = 0, ..., N-1.

Basis matrix generator **140** receives as input (i.1) a Gabor matrix G, such as the matrix given by **Equations (5)** and **(6)** above; and generates as output (o.1) an NxN basis matrix, F = ($f_{mn}$). In one embodiment of the present invention, the output of basis matrix generator **140** is generated according to the following equation.

$$F = (G*)^{-1}, \qquad (9)$$

where G* denotes the conjugate transpose of G.

As with computation of G, for the choice of the Gaussian function given by **Equation (6)**, computation of the matrix elements $f_{mn}$ given by **Equation (9)** may be optimized to avoid redundant computations. The $j^{th}$ column vector, **f**, of the matrix F can be computed by solving the linear system G*$\underline{\mathbf{f}} = \underline{\mathbf{e}}$, where $\underline{\mathbf{e}}$ is the N-vector with a 1 in the $j^{th}$ entry and zeros elsewhere. It can be shown from **Equation (8)** above that the other columns of F can be derived from the $j^{th}$ column of F, by the same relationship as in **Equation (8)**; namely,

$$f_{mn} = \exp\left(2m\pi i\, \frac{b}{B}\right) \begin{cases} f_{m-Ba\ j}, & 0 \le m - Ba < N \\ f_{m-Ba+N\ j}, & -N \le m - Ba < 0 \\ f_{m-Ba-N\ j}, & N \le m - Ba < 2N \end{cases} \qquad (10)$$

It will be appreciated by those skilled in the art that the present invention generalizes to the case where the rectangle R, used by function shapes generator **120**, is sub-divided into N non-uniform rectangles of respective dimensions $\Delta T_n$ and $\Delta\Omega_n$. In such case, the spreads,

$$a_n = \Delta\Omega_n \,/\, (2\,\Delta T_n) \qquad (11)$$

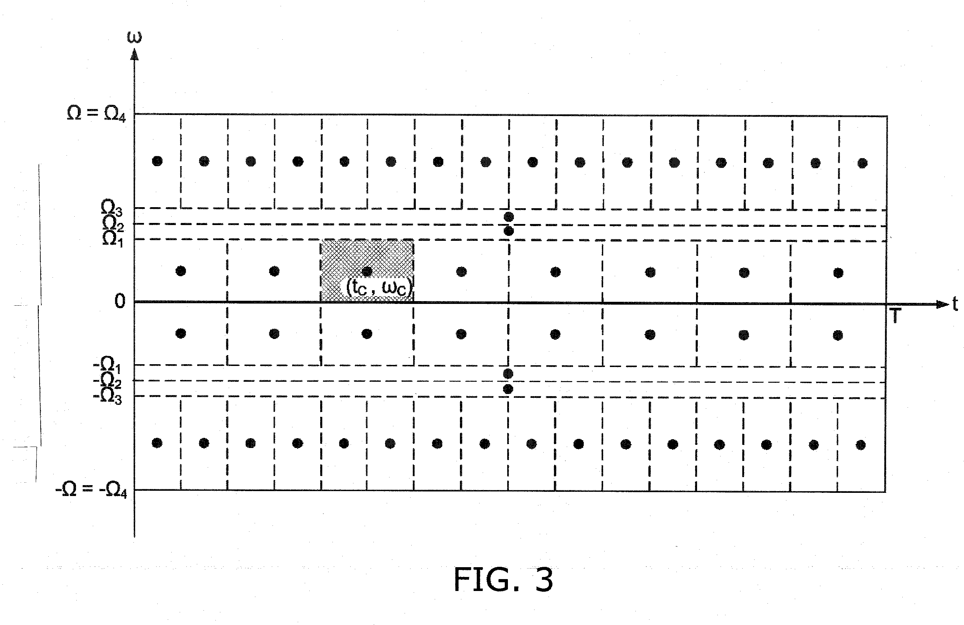

may vary for each small rectangle. In this regard, reference is made to **FIG. 3,** which is a simplified diagram of a non-uniform geometry for locations of centers of Gaussian functions, in accordance with an embodiment of the present invention.

Non-uniform geometries are useful for compressing different frequency scales at different resolutions. For example, if signal frequencies in a range $[\Omega_3, \Omega_4]$ are substantially indistinguishable, or if the signal frequencies in the range $[\Omega_3, \Omega_4]$ appear at the same time, then the geometry of **FIG. 3** is of advantage. For the geometry shown in **FIG. 3**, N = 52.

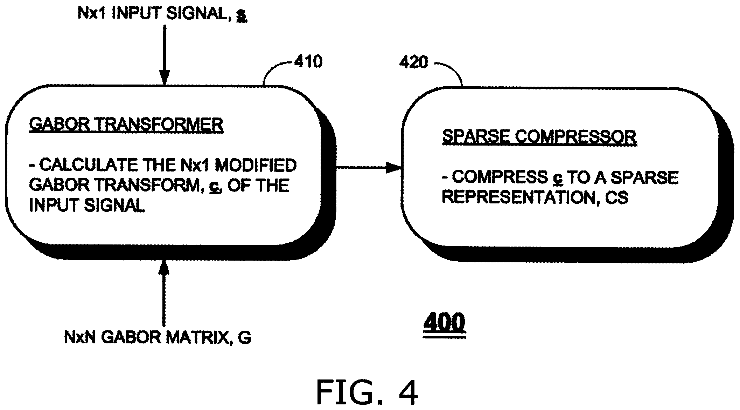

Reference is made to **FIG. 4,** which is a simplified block diagram of a signal compressor **400,** using a Gabor matrix, in accordance with an embodiment of the present invention. Signal compressor **400** includes two components; namely, a Gabor transformer **410,** and a sparse compressor **420.**

Gabor transformer **410** accepts as inputs (i.1) a discrete-time signal $\underline{\mathbf{s}}$ =(s[n]: n = 0, ..., N-1), and (i.2) an NxN Gabor matrix G=($g_{mn}$), such as the matrix G given by **Equations (5)** and **(6)** above; and generates as (o.1) output a transformed signal $\underline{\mathbf{c}}$ =(c[n]: n = 0, ..., N-1). In some embodiments of the present invention, the signal values s[n] are samples of a continuous-time signal S(t); i.e., s[n] = S($t_n$). In accordance with one embodiment of the present invention, Gabor transformer **410** generates its output according to the following equation.

$$\underline{c} = G^*\underline{s} \qquad\qquad (12)$$

For the Gabor matrix G given by **Equations (5)** and **(6)** above, it will be appreciated by those skilled in the art that when the signal values s[n] are real-valued, for each entry of the vector **c** its complex conjugate is also an entry **of c**, since the corresponding row entries of G, $g(t_m - t_{Cn}, \omega_{Cn}; \alpha)$ and $g(t_m - t_{Cn}, -\omega_{Cn}; a)$, are all conjugates, for $0 \le \omega_{Cn} < \Omega$.

Sparse compressor **420** accepts as input (i.1) a vector **c**, such as the transformed vector given by **Equation (12)** above; and generates as output (o.1) a sparse representation, CS, of **c**. In one embodiment of the present invention, sparse compressor **420** generates its output by zeroing of near-zero entries of **c** and run-length encoding the resulting entries. The zeroing of near-zero entries is based on a designated cutoff size; i.e., entries of **c** below the cutoff size are set to zero.

One of the primary advantages of the present invention is that in general, the vector **c** has many near-zero components, and can thus be compressed significantly by run-length encoding. The zeroing of near-zero entries of **c** causes a small amount of loss of the original signal **s**. As such, signal compressor **400** is a lossy compressor.

An implementation of compressor **400** is provided in the detailed listing of computer source code, written in the Matlab programming language, in **Appendix A**. The source code processes an original audio digital signal, splat.mat, constructs the Gabor matrix, G, in accordance with **Equations (5)** and **(6)**, applies the matrix G* to the original signal, in accordance with **Equation (12)**, zeros out the resulting coefficients that are below a designated cutoff size, and run-length encodes the resulting data to generate the compressed signal.

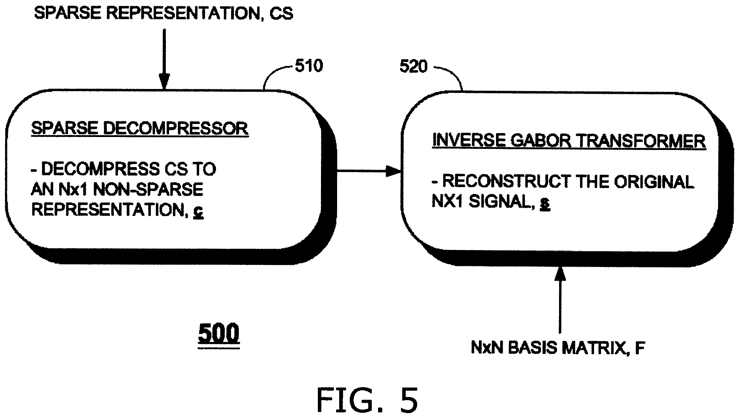

Reference is made to **FIG. 5**, which is a simplified block diagram of a signal decompressor **500**, using a basis matrix, in accordance with an embodiment of the present invention. Signal decompressor **500** includes two components; namely, a sparse decompressor **510**, and an inverse Gabor transformer **520**.

Sparse decompressor **510** substantially inverts the operation of sparse compressor **420**. Specifically, sparse compressor **510** receives as input (i.1) a sparse representation, CS, of an N-vector **c**; and generates (o.1) the vector **c** therefrom as output. In one embodiment of the present invention, sparse decompressor **510** generates its output by run-length decoding of **c**.

Inverse Gabor transformer **520** inverts the operation of Gabor transformer **410**. Inverse Gabor transformer **520** receives as input (i.1) an N-vector **c**, and (i.2) an NxN basis matrix F, such as the matrix F given by **Equation (9)** above, and generates as output (o.1) an N-vector **s** corresponding to the discrete-time signal (s[n]: n = 0, ..., N-1). In one embodiment of the present invention, inverse Gabor transformer **420** generates its output through the following equation.

$$\underline{s} = F\underline{c} \qquad\qquad (13)$$

An implementation of decompressor 500 is provided in the detailed listing of computer source code, written in the Matlab programming language, in **Appendix A**. The source code processes a compressed audio digital signal, run-length decodes the coefficients, constructs the basis matrix, F, according to **Equation (9)**, and applies the matrix F to the run-length decoded coefficients, in accordance with **Equation (13)**, to generate the reconstructed signal. The original and reconstructed audio may be heard by playing respective digital signals.

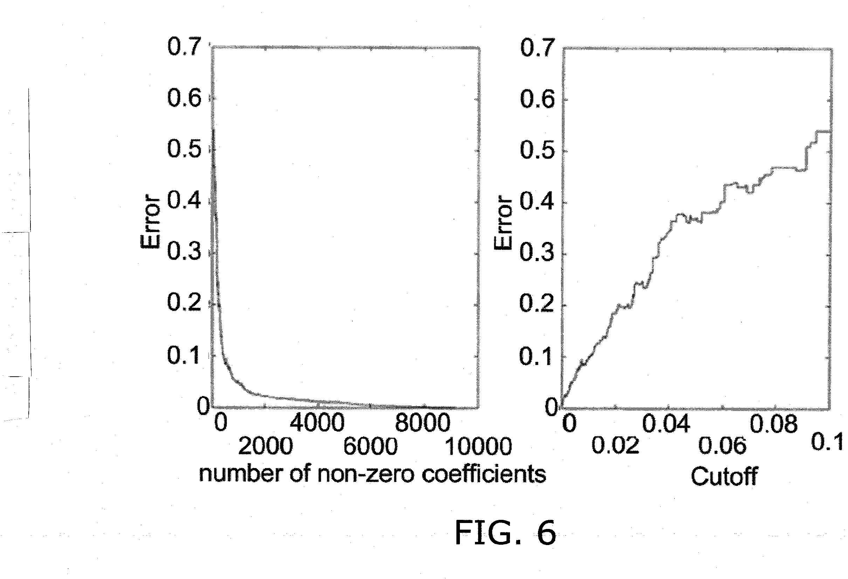

In a sample simulation, the Matlab program in **Appendix A** compressed an audio signal of 9216 samples using only 1070 basis coefficients, with negligible loss. Reference is made to **FIG. 6,** which shows two plots of the error, for this sample simulation, between the original signal and the reconstructed signal, after normalization of the coefficients. The original signal and reconstructed signal were normalized by dividing each entry of a respective signal by the square root of the sum of the squares of the magnitudes of all entries of the signal. The error was calculated as the square root of the sum of the squares of the magnitudes of the entries of the difference between the normalized signals. The left plot shows the error as a function of the number of non-zero coefficients, and the right plot shows the error as a function of the cutoff size. A cutoff size of 0.02 resulted in a reconstructed signal with negligible loss in quality. A cutoff size of 0.003 resulted in a reconstructed signal with imperceptible loss. In general, choice of a cutoff size is application-specific, and depends on a required level of accuracy.

In another sample simulation, an audio signal of 3584 samples was compressed using Gaussian basis functions corresponding to a partition of 32 frequency intervals and 128 time intervals. After normalization as above, a cutoff size of $8.0 \times 10^{-6}$ resulted in a compression ratio of 0.32 with imperceptible loss in quality. The same simulation using a conventional Fourier transform, resulted in less compression.

## Application of the Invention to Digital Image Compression

The methods and systems for signal compression described hereinabove readily apply to compression of digital images and higher-dimensional data structures. For an N1xN2 image (s[n1][n2]: n1 = 0, ...N1-1; n2 = 0, ..., N2-1), for

sampling locations $x1_n$, n = 0, ..., N1-1 in a first dimension, and for sampling locations $x2_n$, n = 0, ..., N2-1 in a second dimension, define the N1xN1 matrix G1 = $(g1_{mn})$ for the first dimension by

$$g1_{mn} = g(x1_m - x1_{Cn}, \omega_{Cn}; \alpha) , \qquad (14)$$

for m = 0, ..., N1-1 and n = 0, ..., N1-1, and define the N2xN2 matrix G2 = $(g2_{mn})$ for the second dimension by

$$g2_{mn} = g(x2_m - x2_{Cn}, \omega_{Cn}; \alpha) \qquad (15)$$

for m = 0, ..., N2-1 and n = 0, ..., N2-1, where $g(x, \omega; \alpha)$ is given by **Equation (6)** above . Then the two-dimensional Gabor transformer is given by

$$c[n1][n2] = \sum_{m1=1}^{N1} \sum_{m2=1}^{N2} \overline{g1_{n1\,m1}} \ \overline{g2_{n2\,m2}} \ s[m1][m2] \qquad (16)$$

for m1 = 0, ..., N1-1 and m2 = 0, ..., N2-1, where $\bar{g}$ denotes the complex conjugate of g. Corresponding, the two-dimensional inverse Gabor transformer is given by

$$s[n1][n2] = \sum_{m1=1}^{N1} \sum_{m2=1}^{N2} f1_{n1\,m1} \ f2_{n2\,m2} \ c[m1][m2] , \qquad (17)$$

where F1 = $(f_{mn})$ is the N1xN1 matrix for the first dimension given by

$$F1 = (G1*)^{-1} , \qquad (18)$$

and F2 = $(f2_{mn})$ is the N2xN2 matrix for the second dimension given by

$$F2 = (G2*)^{-1} , \qquad (19)$$

As in the one-dimensional case, generally many of the entries c[n1][n2] are near-zero, and may be replaced by zeros without noticeable loss of image quality.

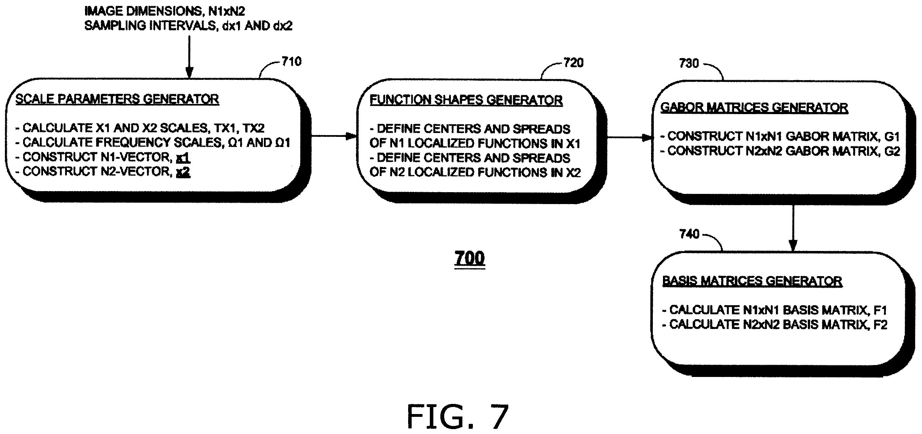

Reference is made to **FIG. 7**, which is a simplified block diagram of a system **700** for constructing Gabor matrices, G1 and G2, and basis matrices, F1 and F2, which are used for compressing and decompressing a digital image, in accordance with an embodiment of the present invention. The system in **FIG. 7** includes four components; namely, a scale parameters generator **710**, a function shapes generator **720**, a Gabor matrices generator **730**, and a basis matrices generator **740**.

Scale parameters generator **710** receives as input (i.1) image dimensions N1xN2, (i.2) a first spatial sampling interval, dx1, and (i.3) a second spatial sampling interval dx2; and generates as output (o.1) a first spatial frequency scale, TX1, (o.2) a second spatial frequency scale, TX2, (o.3) a first spatial sampling N1-vector **x1** = $(x1_n$: n = 0, ..., N1-1), and (o.4) a second spatial sampling N2-vector **x2** = $(x2_n$: n = 0, ..., N-1).

Function shapes generator **720** receives as input (i.1) image dimensions N1xN2 N, (i.2) a first spatial frequency scale, TX1, and (i.3) a second spatial frequency scale, TX2; and generates as output (o.1) centers, $(x1_{Cn}, \omega_{Cn})$, for n = 0, ..., N1-1, (o.2) a first spread, $\alpha1$, (o.3) centers, $(x2_{Cn}, \omega_{Cn})$, for n = 0, ..., N2-1, and (o.4) a second spread, $\alpha2$.

Gabor matrices generator **730** receives as input (i.1) a first spatial sampling N1-vector **x1** = $(x1_n$: n = 0, ..., N1-1), (i.2) N1 centers $(x1_{Cn}, \omega_{Cn})$, (i.3) a first spread $\alpha1$, (i.4) a second spatial sampling N2-vector **x2** = $(x2_n$: n = 0, ..., N2-1), (i.5) N2 centers $(x2_{Cn}, \omega_{Cn})$, and (i.6) a second spread $\alpha2$; and generates as output (o.1) a first N1xN1 Gabor matrix, G1 = $(g1_{mn})$, and (o.2) a second N2xN2 Gabor matrix, G2 = $(g2_{mn})$. In one embodiment of the present invention, the Gabor matrices G1 and G2 are generated according to respective **Equations (14)** and **(15)** above.

Basis matrices generator **740** receives as input (i.1) a first Gabor matrix G1, and (i.2) a second Gabor matrix G2; and generates as output (o.1) a first N1xN1 basis matrix, F1 = $(f1_{mn})$, and (o.2) a second N2xN2 basis matrix, F2 = $(f2_{mn})$. In one embodiment of the present invention, the basis matrices F1 and F2 are generated according to respective **Equations (18)** and **(19)** above.

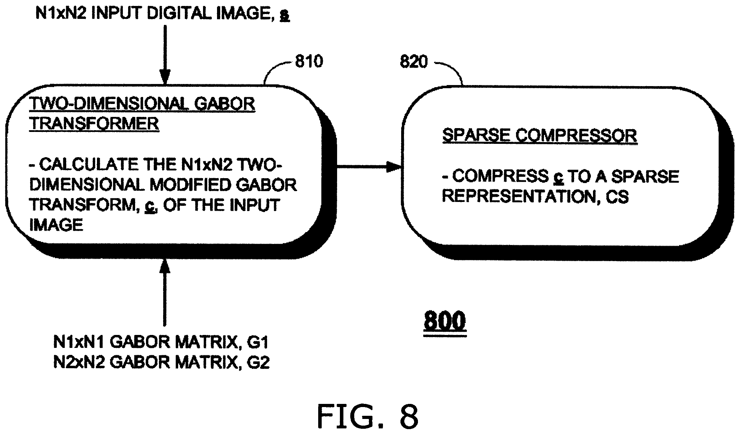

Reference is made to **FIG. 8**, which is a simplified block diagram of a digital image compressor **800**, using two Gabor matrices, in accordance with an embodiment of the present invention. Digital image compressor **800** includes two components; namely, a two-dimensional Gabor transformer **810,** and a sparse compressor **820.**

Two-dimensional Gabor transformer **810** accepts as inputs (i.1) a digital image $\underline{s}$ = (s[n1][n2]: n1 = 0, ...N1-1; n2 = 0, ..., N2-1), (i.2) a first N1xN1 Gabor matrix G1=(g1$_{mn}$), such as the matrix G1 given by **Equation (14)** above, and (i.3) a second N2xN2 Gabor matrix G2=(g2$_{mn}$), such as the matrix G2 given by **Equation (15)** above; and generates as output (o.1) a transformed image $\underline{c}$ = (c[n1][n2]: n1 = 0, ...N1-1; n2 = 0, ..., N2-1). In accordance with one embodiment of the present invention, two-dimensional Gabor transformer **810** generates its output according to **Equation (16)** above.

Sparse compressor **820** accepts as input (i.1) a digital image $\underline{c}$, such as the transformed digital image given by **Equation (16)** above; and generates as output (o.1) a sparse representation, CS, of $\underline{c}$. In one embodiment of the present invention, sparse compressor **820** generates its output by zeroing of near-zero entries of $\underline{c}$ and run-length encoding the resulting entries. The zeroing of near-zero entries is based on a designated cutoff size; i.e., entries of $\underline{c}$ below the cutoff size are set to zero.

One of the primary advantages of the present invention is that in general, the digital image $\underline{c}$ has many near-zero components, and can thus be compressed significantly by run-length encoding. The zeroing of near-zero entries of $\underline{c}$ causes a small amount of loss of the original signal $\underline{c}$. As such, digital image compressor **800** is a lossy compressor.

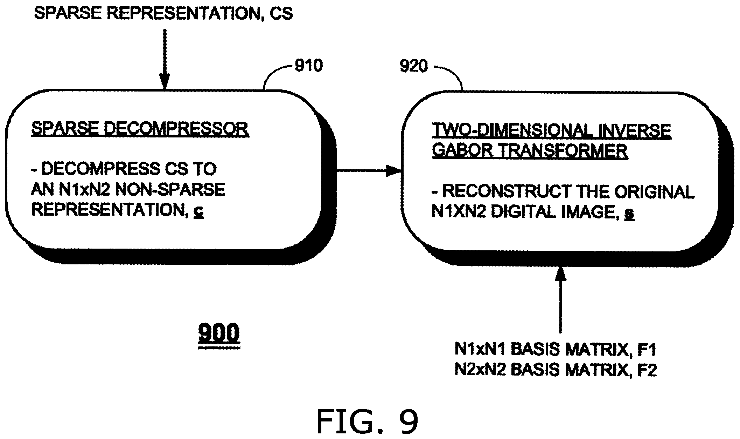

Reference is made to **FIG. 9,** which is a simplified block diagram of a digital image decompressor **900,** using two basis matrices, in accordance with an embodiment of the present invention. Digital image decompressor **900** includes two components; namely, a sparse decompressor **910,** and a two-dimensional inverse Gabor transformer **920.**

Sparse decompressor **910** substantially inverts the operation of sparse compressor **820.** Specifically, sparse compressor **910** receives as input (i.1) a sparse representation, CS, of an N1xN2 digital image $\underline{c}$; and generates (o.1) the digital image $\underline{c}$ therefrom as output. In one embodiment of the present invention, sparse decompressor **910** generates its output by run-length decoding of $\underline{c}$.

Two-dimensional inverse Gabor transformer **920** inverts the operation of two-dimensional Gabor transformer **810.** Inverse Gabor transformer **920** receives as input (i.1) an N1xN2 digital image $\underline{c}$, (i.2) a first N1xN1 basis matrix F1, such as the matrix F1 given by **Equation (18)** above, and (i.3) a second N2xN2 basis matrix F2, such as the matrix F2 given by **Equation (19)** above; and generates as output (o.1) an N1xN2 digital image $\underline{s}$ corresponding to the digital image ((s[n1][n2]: n1 = 0, ...N1-1; n2 = 0, ..., N2-1)). In one embodiment of the present invention, two-dimensional inverse Gabor transformer **920** generates its output through **Equation (17)** above.

It will be appreciated by those skilled in the art that the methods and systems described above apply to non-Gaussian basis functions. The description hereinabove relates to the Gabor basis and the wavelet basis because these are familiar bases with attractive properties, but in fact any set of linearly independent compactly supported functions may be used in accordance with the present invention to compress and reconstruct a signal. Similarly, any set of linearly independent compactly supported functions with two spatial arguments may be used in accordance with the present invention to compress and reconstruct an image.

It will further be appreciated by those skilled in the art that the present invention has wide-spread advantage in many application areas, including inter alia storage of information, processing and communication for acoustical and optical signals.

In the foregoing specification, the invention has been described with reference to specific exemplary embodiments thereof. It will, however, be evident that various modifications and changes may be made to the specific exemplary embodiments without departing from the broader scope of the invention as set forth in the appended claims. Accordingly, the specification and drawings are to be regarded in an illustrative rather than a restrictive sense.

## APPENDIX A

clear

```
%load 'fh.mat'
load 'splat'% load an audio digital signal
cutoff=3e-3; %Each (normalized) Gabor coefficient under cutoff
will be removed
%%%%%%%%%%%%%%%%%%%%%%%%%%%%%%%%%%%%%%%%%%
%                                        %
%                                        %
%                                        %
%                                        %
  N_pvn=3072; %
  y=y(1:N_pvn*3); %
%%%%%%%%%%%%%%%%%%%%%%%%%%%%%%%%%%%%%%%%%%
```

```
%%%%%%%%%%%%%%%%%%%%%%%%%%%%%%%%%%%%%%%
%                                     %
% Define the Gabor function parameters %
%                                     %
dt=1/(8192-1); %
tmin=0; %
tmax=(N_pvn-1)*dt;
%%%%%%%%%%%%%%%%%%%%%%%%%%%%%%%%%%
t=tmin:dt:tmax; %t vector%
nom=96; %number of Gabor functions in omega%
nt=32; %number of Gabor functions in t%
t_mid=(t(1)+t(end)+dt)/2; %
Rt=dt+t(end)-t(1); %time range =N*dt%
Rom=1*2*pi/dt; %omega range %
DT=Rt/nt; % space between Gabor functions in time%
DOM=Rom/nom; % space between Gabor functions in omega%
alpha=DOM/(2*DT); %width parameter%
t_0=[ t_mid-(nt/2-0.5)*DT:DT:t_mid+(nt/2-0.5)*DT ]; %centers
of Gaussian in t%%
om_0=[ 0-(nom/2-0.5)*DOM:DOM:0+(nom/2-0.5)*DOM ]; %centers
of Gaussian in omega%
%%%%%%%%%%%%%%%%%%%%%%%%%%%%%%%%%%%%%%%%%%%%%%%%%%%%%%%%%%%%%
%%%%%%%%%%%%%%%%%%%%%%%%%%%%%%%%%%%
%Construct the Gabor matrix G%
%%%%%%%%%%%%%%%%%%%%%%%%%%%%%%%%%%%%%%%%%%%%%%%%%%%%%%%%%%%%%
NN=0;%
G=zeros(N_pvn,N_pvn);%
for 1=1:nom%
  for m=1:nt%
    NN=NN+1;%
%
g=(2*alpha/pi)^0.25*exp(-alpha*(t-t_0(m))^2+i/1*om_0(1).*(t-
t_0(m))); %
  G(:,NN)=g; %
  end%
end%%
   %%%%%%%%%%%%%%%%%%%%%%%%%%%%%%%%%%%%%%%%%%%%%%%%%%%%%%%%%%%%%
   %%%%%%%%%%%%%%%%%%%%%%%%%%%%%%%
   %CALCULATE THE BASIS MATRIX F%
                               %
   f=inv(G');                  %
%%%%%%%%%%%%%%%%%%%%%%%%%%%%%%%%%%%%
%%%%%%%%%%%%%%%%%%%%%%%%%%%%%%%%%%%%%%%%%%
%                                       %
% PERFORM THE GABOR TRANSFORM           %
%                                       %
%                                        %
%                                        %
for k=1:3;
yt=y((1+(k-1)*N_pvn):k*N_pvn);
coef=G'*yt; %The Gabor transform
k
%%%%%%%%%%%%%%%%%%%%%%%%%%%%%%%%%%%%%%%%%
%
%
%        Remove small coefficients
cn=(1/(coef'*coef))^0.5*coef; %normalization of the
coefficients vector
indx=(find(abs(cn)<=cutoff));
coef(indx)=0; %zeroing the coefficients below cutoff
%%%%%%%%%%%%%%%%%%%%%%%%%%%%%%%%%%%%%%%%%%%%%%
%%%%%%%%%%%%%%%%%%%%%%%%%%%%%%%%%%%%%%%%%%%%%%%%%%%%%%%%
%
```

```
%       RECONSTRUCT THE ORIGINAL SIGNAL
%
yr((1+(k-1)*N_pvn):k*N_pvn)=f*coef;
yr=real(yr. ');
end
sound(real(y),Fs) %hear the original signal
sound(real(yr),Fs) %hear the reconstructed signal
```

**Claims**

1. A signal processor for compressing signal data, comprising:

   a function shapes generator for receiving as input time and frequency scale parameters, and for generating as output a plurality of shape parameters for a corresponding plurality of localized functions, wherein the shape parameters govern the centers and spreads of the localized functions;
   a matrix generator, coupled with said function shapes generator, for receiving as input the plurality of shape parameters generated by said function shapes generator, and a sequence of sampling times, and for generating as output a matrix whose elements are the values of the localized functions at the sampling times, wherein each column of the matrix corresponds to one of the localized functions, wherein each row of the matrix corresponds to one of the sampling times, and wherein the matrix has a conjugate transpose matrix;
   a signal transformer, coupled with said matrix generator, for receiving as input an original signal, and the matrix generated by said matrix generator, and for generating as output a transformed signal by applying the conjugate transpose matrix to the original signal; and
   a signal compressor, coupled with said signal transformer, for receiving as input the transformed signal generated by said signal transformer, and for generating as output a compressed representation of the transformed signal.

2. The signal processor of claim 1, wherein
   said function shapes generator receives as input spatial and frequency scale parameters;
   wherein said matrix generator receives as input first and second sequences of spatial sampling points, and generates as output (i) a first matrix whose elements are the values of the localized functions at the first sequence of spatial sampling points, wherein each column of the first matrix corresponds to one of the localized functions, and wherein each row of the first matrix corresponds to one of the spatial sampling points from the first sequence, and (ii) a second matrix whose elements are the values of the localized functions at the second sequence of spatial sampling points, wherein each column of the second matrix corresponds to one of the localized functions, and wherein each row of the second matrix corresponds to one of the spatial sampling points from the second sequence;
   and further comprising:

   an image transformer, coupled with said matrix generator, for receiving as input an original digital image, and the first and second matrices generated by said matrix generator, and for generating as output a transformed image by applying the matrices to the original digital image; and
   an image compressor, coupled with said image transformer, for receiving as input the transformed image generated by said image transformer, and for generating as output a compressed representation of the transformed image.

3. A signal processor for decompressing compressed signal data, comprising:

   a function shapes generator for receiving as input time and frequency scale parameters, and for generating as output a plurality of shape parameters for a corresponding plurality of localized functions, wherein the shape parameters govern the centers and spreads of the localized functions;
   a matrix generator, coupled with said function shapes generator, for receiving as input the plurality of shape parameters generated by said function shapes generator, and a sequence of sampling times, and for generating as output a matrix whose elements are the values of the plurality of localized functions at the sampling times, wherein each column of the matrix corresponds to one of the localized functions, and wherein each row of the matrix corresponds to one of the sampling times;
   a matrix inverter, coupled with said matrix generator, for inverting the conjugate transpose matrix for the matrix generated by said matrix generator;
   a signal decompressor for receiving as input a compressed representation of a signal, and for generating as

13

output a decompressed signal; and

a signal transformer, coupled with said signal decompressor and with said matrix inverter, for receiving as input the decompressed signal generated by said signal decompressor, and the inverse conjugate transpose matrix generated by said matrix inverter, and for generating as output a reconstructed signal corresponding to the result of applying the inverse conjugate transpose matrix to the decompressed signal.

4. The signal processor of claim 3
wherein said function shapes generator receives as input spatial and frequency scale parameters;
wherein said matrix generator receives as input first and second sequences of spatial sampling points, and generates as output (i) a first matrix whose elements are the values of the plurality of localized functions at the first sequence of spatial sampling points, wherein each column of the first matrix corresponds to one of the localized functions, and wherein each row of the first matrix corresponds to one of the spatial sampling points from the first sequence, and (ii) a second matrix whose elements are the values of the plurality of localized functions at the second sequence of spatial sampling points, wherein each column of the second matrix corresponds to one of the localized functions, and wherein
each row of the second matrix corresponds to one of the spatial sampling points from the second sequence;
wherein the matrix inverter, coupled with said matrix generator, inverts the conjugate transposes of the first and second matrices generated by said matrix generator; and further comprising:

an image decompressor for receiving as input a compressed representation of a digital image, and for generating as output a decompressed digital image; and

a digital image transformer, coupled with said image decompressor and with said matrix inverter, for receiving as input the decompressed digital image generated by said image decompressor, and the inverse conjugate transpose matrices generated by said matrix inverter, and for generating as output a reconstructed digital image corresponding to the result of applying the inverse conjugate transpose matrices to the decompressed digital image.

5. The signal processor of any one of the claims 1 to 4 wherein the localized functions are linearly independent compactly supported functions.

6. The signal processor of any one of the claim 1 to 4 wherein the localized functions are Gaussian functions.

7. The signal processor of any one of the claim 1 to 4 wherein the localized functions are wavelet Gaussian functions.

8. The signal processor of claim 1 or 2 wherein said function shapes generator generates shape parameters for centers that are equally spaced apart.

9. The signal processor of claim 1 or 2 wherein said function shapes generator generates shape parameters for centers that are not equally spaced apart.

10. The signal processor of any one of the claims 1 or 3 wherein the original signal is a discrete time series generated by sampling a continuous-time signal, and wherein the localized functions are substantially localized to a rectangle of area $2\pi$ in time-frequency space.

11. The signal processor of any one of the claims 1 or 3 wherein said matrix generator comprises:

a first column generator for generating one column of the matrix by evaluating the values of one of the localized functions at the plurality of positions; and

a remainder column generator for generating the remaining columns of the matrix by applying complex exponential multipliers to elements of the one column.

12. The signal processor of claim 3 wherein said matrix inverter comprises: a first column generator for generating one column of the inverse conjugate transpose matrix; and

a remainder column generator for generating the remaining columns of the inverse conjugate transpose matrix by applying complex exponential multipliers to elements of the one column generated by said first column generator.

13. The signal processor of claim 2 or 4, wherein the localized functions are substantially localized to a rectangle of area $2\pi$ in space-frequency space.

**14.** The signal processor of claim 2 or 4 wherein said matrix generator comprises:

a first columns generator for generating one column of the first matrix by evaluating the values of a first one of the localized functions at the plurality of positions, and for generating one column of the second matrix by evaluating the values of a second one of the localized functions at the plurality of positions; and

a remainder columns generator for generating the remaining columns of the first matrix by applying complex exponential multipliers to elements of the one column of the first matrix, and for generating the remaining columns of the second matrix by applying complex exponential multipliers to elements of the one column of the second matrix.

**15.** The signal processor of claim 4 wherein said matrix inverter comprises:

a first columns generator for generating one column of the inverse conjugate transpose of the first matrix, and for generating one column of the inverse conjugate transpose of the second matrix; and

a remainders column generator for generating the remaining columns of the inverse conjugate transpose of the first matrix by applying complex exponential multipliers to elements of the one column of the inverse conjugate transpose of the first matrix generated by said first column generator, and for generating the remaining columns of the inverse conjugate transpose of the second matrix by applying complex exponential multipliers to elements of the one column of the inverse conjugate transpose of the second matrix generated by said first column generator.

## Patentansprüche

**1.** Signalprozessor zum Komprimieren von Signaldaten, das Folgende umfassend:

einen Funktionsformengenerator zum Empfangen von Zeit- und Häufigkeitsverteilungsparametern als Eingang und zum Erzeugen einer Vielzahl von Formparametern für eine entsprechende Vielzahl von lokalisierten Funktionen als Ausgang, wobei die Formparameter die Zentren und die Spreizungen der lokalisierten Funktionen regulieren;

einen Matrixgenerator, der mit dem Funktionsformengenerator gekoppelt ist, um die Vielzahl der durch den Funktionsformengenerator erzeugten Formparameter als Eingang zu empfangen, und eine Sequenz von Abtastzeiten und um eine Matrix, deren Elemente die Werte der lokalisierten Funktionen zu den Abtastzeiten sind, als Ausgang zu erzeugen, wobei jede Reihe der Matrix einer der lokalisierten Funktionen entspricht, wobei jede Reihe der Matrix einer der Abtastzeiten entspricht, und wobei die Matrix eine Konjugiert-Transponierten-Matrix hat;

einen Signalwandler, der mit dem Matrixgenerator gekoppelt ist, um ein Originalsignal als Eingang zu empfangen, und die vom Matrixgenerator erzeugte Matrix, und durch Anwenden der Konjugiert- Transponierten-Matrix auf das Originalsignal Erzeugen eines transformierten Signals als Ausgang; und

einen Signalkompressor, der mit dem Signalwandler gekoppelt ist, um das vom Signalwandler erzeugte transformierte Signal als Eingang zu empfangen, und um eine komprimierte Repräsentation des transformierten Signals als Ausgang zu erzeugen.

**2.** Signalprozessor nach Anspruch 1, wobei

der Funktionsformengenerator Raum- und Häufigkeitsverteilungsparameter als Eingang empfängt;

wobei der Matrixgenerator erste und zweite Sequenzen räumlicher Abtaststellen als Eingang empfängt und als Ausgang (i) eine erste Matrix erzeugt, deren Elemente die Werte der lokalisierten Funktionen an der ersten Sequenz der räumlichen Abtaststellen sind, wobei jede Spalte der ersten Matrix einer der lokalisierten Funktionen entspricht, und wobei jede Reihe der ersten Matrix einer der räumlichen Abtaststellen aus der ersten Sequenz entspricht, und (ii) eine zweite Matrix, deren Elemente die Werte der lokalisierten Funktionen an der zweiten Sequenz der räumlichen Abtaststellen sind, wobei jede Spalte der zweiten Matrix einer der lokalisierten Funktionen entspricht, und wobei jede Reihe der zweiten Matrix einer der räumlichen Abtaststellen der zweiten Sequenz entspricht; und ferner umfassend:

einen Bildwandler, der mit dem Matrixgenerator gekoppelt ist, um ein originales Digitalbild als Eingang zu empfangen, und die erste und die zweite Matrix, die von dem Matrixgenerator erzeugt werden, und um durch Anwenden der Matrizen auf das originale Digitalbild ein transformiertes Bild als Ausgang zu erzeugen; und

einen Bildkompressor, der mit dem Bildwandler gekoppelt ist, um das vom Bildwandler erzeugte transformierte Bild als Eingang zu empfangen und um eine komprimierte Repräsentation des transformierten Bildes als Ausgang zu erzeugen.

3. Signalprozessor zum Dekomprimieren komprimierter Signaldaten, das Folgende umfassend:

einen Funktionsformengenerator, um Zeit- und Häufigkeitsverteilungsparameter als Eingang zu empfangen und um eine Vielzahl von Formparametern für eine entsprechende Vielzahl von lokalisierten Funktionen als Ausgang zu erzeugen, wobei die Formparameter die Zentren und Spreizungen der lokalisierten Funktionen regulieren;

einen Matrixgenerator, der mit dem Funktionsformengenerator gekoppelt ist, um die Vielzahl der vom Funktionsformengenerator erzeugten Formparameter als Eingang zu empfangen und eine Sequenz von Abtastzeiten, und um eine Matrix, deren Elemente die Werte der lokalisierten Funktionen zu den Abtastzeiten sind, als Ausgang zu erzeugen, wobei jede Spalte der Matrix einer der lokalisierten Funktionen entspricht, und wobei jede Reihe der Matrix einer der Abtastzeiten entspricht;

ein Matrixinvertierer, der mit dem Matrixgenerator gekoppelt ist, um die Konjugiert-Transponierte-Matrix für die vom Matrixgenerator erzeugte Matrix zu invertieren;

einen Signaldekomprimierer, um eine komprimierte Repräsentation eines Signals als Eingang zu empfangen, und um ein dekomprimiertes Signal als Ausgang zu erzeugen; und

einen Signalwandler, der mit dem Signaldekomprimierer und dem Matrixinvertierer gekoppelt ist, um das dekomprimierte vom Signaldekomprimierer erzeugte Signal als Eingang zu empfangen, und die vom Matrixinvertierer erzeugte inverse Konjugiert-Transponierte-Matrix, um ein rekonstruiertes Signal, das dem Anwendungsergebnis der inversen Konjugiert-Transponierte-Matrix auf das dekomprimierte Signal entspricht, als Ausgang zu erzeugen.

4. Signalprozessor nach Anspruch 3,
wobei der Funktionsformengenerator Raum- und Häufigkeitsverteilungsparameter als Eingang empfängt;
wobei der Matrixgenerator erste und zweite Sequenzen räumlicher Abtaststellen als Eingang empfängt und (i) eine erste Matrix, deren Elemente die Werte der Vielzahl der lokalisierten Funktionen an der ersten Sequenz räumlicher Abtaststellen sind, als Ausgang erzeugt, wobei jede Spalte der ersten Matrix einer der lokalisierten Funktionen entspricht, und wobei jede Reihe der ersten Matrix einer der räumlichen Abtaststellen aus der ersten Sequenz entspricht; und (ii) eine zweite Matrix, deren Elemente die Werte der Vielzahl der lokalisierten Funktionen an der zweiten Sequenz räumlicher Abtaststellen sind, wobei jede Spalte der zweiten Matrix einer der lokalisierten Funktionen entspricht, und wobei
jede Reihe der zweiten Matrix einer der räumlichen Abtaststellen aus der zweiten Sequenz entspricht;
wobei der Matrixinvertierer, der mit dem Matrixgenerator gekoppelt ist, die vom Matrixgenerator erzeugte Konjugiert-Transformierte der ersten und der zweiten Matrix invertiert, und ferner umfassend:

einen Bild-Dekomprimierer, um eine komprimierte Repräsentation eines digitalen Bildes als Eingang zu empfangen und um ein dekomprimiertes digitales Bild als Ausgang zu erzeugen; und

einen digitalen Bildwandler, der mit dem Bild-Dekomprimierer und mit dem Matrixinvertierer gekoppelt ist, um das vom Bild-Dekomprimierer erzeugte dekomprimierte digitale Bild als Eingang zu empfangen, und die invertierten vom Matrixinvertierer erzeugten Konjugat-Transponierte-Matrizen, und um ein rekonstruiertes digitales Bild, das dem Anwendungsergebnis der inversen Konjugat-Transponierten-Matrizen auf das dekomprimierte digitale Bild entspricht, als Ausgang zu erzeugen.

5. Signalprozessor nach einem der Ansprüche 1 bis 4, wobei die lokalisierten Funktionen linear unabhängige, kompakt unterstützte Funktionen sind.

6. Signalprozessor nach einem der Ansprüche 1 bis 4, wobei die lokalisierten Funktionen Gauß-Funktionen sind.

7. Signalprozessor nach einem der Ansprüche 1 bis 4, wobei die lokalisierten Funktionen Gauß'sche Wavelet-Funktionen sind.

8. Signalprozessor nach Anspruch 1 oder 2, wobei der Funktionsformengenerator Formparameter für gleichmäßig beabstandete Zentren erzeugt.

9. Signalprozessor nach Anspruch 1 oder 2, wobei der Funktionsformengenerator Formparameter für nicht gleichmäßig beabstandete Zentren erzeugt.

10. Signalprozessor nach einem der Ansprüche 1 oder 3, wobei das Originalsignal eine diskrete Zeitserie ist, die durch Abtasten eines kontinuierlichen Zeitsignals erzeugt wird, und wobei die lokalisierten Funktionen im Wesentlichen in Bezug auf ein Rechteck einer Fläche $2\pi$ im Zeitfrequenzraum lokalisiert sind.

11. Signalprozessor nach einem der Ansprüche 1 oder 3, wobei der Matrixgenerator das Folgende umfasst:

   einen ersten Spaltengenerator zum Erzeugen einer Spalte der Matrix durch Bewerten der Werte einer der lokalisierten Funktionen an der Vielzahl von Positionen; und
   einen Restspaltengenerator zum Erzeugen der restlichen Spalten der Matrix durch Anwenden komplexer Exponentialmultiplikatoren auf Elemente der einen Spalte.

12. Signalprozessor nach Anspruch 3, wobei der Matrixinvertierer das Folgende umfasst: einen ersten Spaltengenerator zum Erzeugen einer Spalte der inversen Konjugat-Transponierten-Matrix; und einen Restspaltengenerator zum Erzeugen der restlichen Spalten der inversen Konjugat-Transponierten-Matrix durch Anwenden komplexer Exponential-Multiplikatoren auf Elemente der einen vom ersten Spaltengenerator erzeugten Spalte.

13. Signalprozessor nach Anspruch 2 oder 4, wobei die lokalisierten Funktionen im Wesentlichen in Bezug auf ein Rechteck der Fläche $2\pi$ im Raum-Frequenzraum lokalisiert sind.

14. Signalprozessor nach Anspruch 2 oder 4, wobei der Matrixgenerator Folgendes umfasst:

   einen ersten Spaltengenerator zum Erzeugen einer Spalte der ersten Matrix durch Bewerten der Werte einer ersten der lokalisierten Funktionen an der Vielzahl von Positionen und zum Erzeugen einer Spalte der zweiten Matrix durch Bewerten der Werte einer zweiten der lokalisierten Funktionen an der Vielzahl von Positionen; und
   einen Restspaltengenerator zum Erzeugen die restlichen Spalten der ersten Matrix durch Anwenden komplexer Exponential-Multiplikatoren auf Elemente der einen Spalte der ersten Matrix und zum Erzeugen der restlichen Spalten der zweiten Matrix durch Anwenden komplexer Exponential-Multiplikatoren auf Elemente der einen Spalte der zweiten Matrix.

15. Signalprozessor aus Anspruch 4, wobei der Matrixinvertierer das Folgende umfasst:

   einen ersten Spaltengenerator, zum Erzeugen einer Spalte der inversen Konjugat-Transponierten der ersten Matrix und zum Erzeugen einer Spalte der inversen Konjugat-Transponierten der zweiten Matrix; und
   einen Restspaltengenerator zum Erzeugen der restlichen Spalten der inversen Konjugat-Transponierten der ersten Matrix durch Anwenden komplexer Exponential-Multiplikatoren auf Elemente der einen Spalte der inversen Konjugat- Transponierten der ersten durch den ersten Spaltengenerator erzeugten Matrix, und zum Erzeugen der restlichen Spalten der inversen Konjugat- Transponierten der zweiten Matrix durch Anwenden komplexer Exponential-Multiplikatoren auf Elemente der einen Spalte der inversen Konjugat-Transponierten der zweiten durch den ersten Spaltengenerator erzeugten Matrix.

**Revendications**

1. Processeur de signal pour la compression de données de signal, comprenant :

   un générateur de formes de fonctions pour recevoir en tant que paramètres d'entrée de temps et d'échelle de fréquence, et pour générer en sortie une pluralité de paramètres de forme pour une pluralité correspondante de fonctions localisées, dans lequel les paramètres de forme gouvernent les centres et dispersions des fonctions localisées ;
   un générateur de matrice, couplé audit générateur de formes de fonction, pour recevoir en entrée la pluralité de paramètres de forme générés par ledit générateur de formes de fonction, et une séquence d'instants d'échantillonnage, et pour générer en sortie une matrice dont les éléments sont les valeurs des fonctions localisées aux instants d'échantillonnage, dans lequel chaque colonne de la matrice correspond à l'une des fonctions localisées, dans lequel chaque ligne de la matrice correspond à l'un des instants d'échantillonnage, et dans lequel la matrice a une matrice transposée conjuguée ;
   un transformateur de signal, couplé avec ledit générateur de matrice, pour recevoir en entrée un signal original et la matrice générée par ledit générateur de matrice, et pour générer en sortie un signal transformé en appliquant la matrice de la transposée de conjugués au signal original ; et

un compresseur de signal, couplé audit transformateur de signal, pour recevoir en entrée le signal transformé généré par ledit transformateur de signal et pour générer en sortie une représentation comprimée du signal transformé.

2. Processeur de signal selon la revendication 1, dans lequel
ledit générateur de formes de fonctions reçoit en entrée des paramètres spatiaux et d'échelle de fréquence ;
dans lequel ledit générateur de matrice reçoit en entrée des première et seconde séquences d'instants d'échantillonnage spatiaux et génère en sortie (i) une première matrice dont les éléments sont les valeurs des fonctions localisées au niveau de la première séquence d'instants d'échantillonnage spatiaux, dans lequel chaque colonne de la première la matrice correspond à l'une des fonctions localisées et dans lequel chaque rangée de la première matrice correspond à l'un des instants d'échantillonnage spatiaux de la première séquence, et (ii) une deuxième matrice dont les éléments sont les valeurs des fonctions localisées à la deuxième séquence d'instants d'échantillonnage spatiaux, dans lequel chaque colonne de la deuxième matrice correspond à l'une des fonctions localisées, et dans lequel chaque rangée de la deuxième matrice correspond à l'un des instants d'échantillonnage spatiaux de la deuxième séquence ;
et comprenant en outre :

un transformateur d'image, couplé audit générateur de matrice, pour recevoir en entrée une image numérique originale et les première et seconde matrices générées par ledit générateur de matrice, et pour générer en sortie une image transformée en appliquant les matrices à l'image numérique originale ; et
un compresseur d'image, couplé audit transformateur d'image, pour recevoir en entrée l'image transformée générée par ledit transformateur d'image et pour générer en sortie une représentation comprimée de l'image transformée.

3. Processeur de signal pour décompresser des données de signal comprimées, comprenant :

un générateur de formes de fonctions pour recevoir en entrée des paramètres d'échelle de fréquence et de temps et pour générer en sortie une pluralité de paramètres de forme pour une pluralité de fonctions localisées correspondante, dans lequel les paramètres de forme gouvernent les centres et les dispersions des fonctions localisées ;
un générateur de matrice, couplé audit générateur de formes de fonction, pour recevoir en entrée la pluralité de paramètres de forme générés par ledit générateur de formes de fonction, et une séquence d'instants d'échantillonnage, et pour générer en sortie une matrice dont les éléments sont les valeurs de la pluralité des fonctions localisées aux instants d'échantillonnage, dans lequel chaque colonne de la matrice correspondant à l'une des fonctions localisées et chaque rangée de la matrice correspondant à l'un des instants d'échantillonnage ;
un inverseur de matrice, couplé audit générateur de matrice, pour inverser la matrice de la transposée de conjugués pour la matrice générée par ledit générateur de matrice ;
un décompresseur de signal pour recevoir en entrée une représentation comprimée d'un signal et pour générer en sortie un signal décompressé ; et
un transformateur de signal, couplé audit décompresseur de signal et audit inverseur de matrice, pour recevoir en entrée le signal décompressé généré par ledit décompresseur de signal, et la matrice de la transposée de conjugués inverses générée par ledit inverseur de matrice, et pour générer en sortie un signal reconstruit correspondant au résultat de l'application de la matrice de la transposée de conjugués inverses au signal décompressé.

4. Processeur de signal de la revendication 3
Dans lequel ledit générateur de formes de fonctions reçoit en entrée des paramètres spatiaux et d'échelle de fréquence ;
dans lequel ledit générateur de matrice reçoit en entrée des première et seconde séquences de points d'échantillonnage spatial et génère en sortie (i) une première matrice dont les éléments sont les valeurs de la pluralité de fonctions localisées au niveau de la première séquence de points d'échantillonnage spatial, dans laquelle chaque colonne de la première matrice correspond à l'une des fonctions localisées, et dans laquelle chaque rangée de la première matrice correspondant à l'un des points d'échantillonnage spatial de la première séquence, et (ii) une seconde matrice dont les éléments sont les valeurs de la pluralité de fonctions localisées au niveau de la deuxième séquence de points d'échantillonnage spatial, dans laquelle chaque colonne de la deuxième matrice correspond à l'une des fonctions localisées, et dans laquelle chaque ligne de la deuxième matrice correspond à l'un des points d'échantillonnage spatial de la deuxième séquence ;
dans lequel l'inverseur de matrice, couplé audit générateur de matrice, invertit les transposées de conjugués des première et seconde matrices générées par ledit générateur de matrice, et comprenant en outre :

un décompresseur d'image destiné à recevoir en entrée une représentation comprimée d'une image numérique et à générer en sortie une image numérique décompressée ; et
un transformateur d'image numérique, couplé audit décompresseur d'image et audit inverseur matriciel, pour recevoir en entrée l'image numérique décompressée générée par ledit décompresseur d'image, et les matrices inverses de la transposée de conjugués générées par ledit inverseur de matrices, et pour générer en sortie une image numérique reconstruite correspondant au résultat de l'application des matrices inverses de la transposée de conjugués à l'image numérique décompressée.

5. Processeur de signal selon l'une quelconque des revendications 1 à 4, dans lequel les fonctions localisées sont des fonctions linéairement indépendantes prises en charge de manière compacte.

6. Processeur de signal selon l'une quelconque des revendications 1 à 4, dans lequel les fonctions localisées sont des fonctions gaussiennes.

7. Processeur de signal selon l'une quelconque des revendications 1 à 4, dans lequel les fonctions localisées sont des fonctions gaussiennes d'ondelettes.

8. Processeur de signal selon la revendication 1 ou 2, dans lequel ledit générateur de formes de fonction génère des paramètres de forme pour les centres qui sont équidistants.

9. Processeur de signal selon la revendication 1 ou 2, dans lequel ledit générateur de formes de fonction génère des paramètres de forme pour les centres qui ne sont pas équidistants.

10. Processeur de signal selon l'une quelconque des revendications 1 ou 3, dans lequel le signal original est une série temporelle discrète générée en échantillonnant un signal continu dans le temps, et dans lequel les fonctions localisées sont sensiblement localisées dans un rectangle de surface $2\pi$ dans un espace temps-fréquence.

11. Processeur de signal selon l'une quelconque des revendications 1 ou 3, dans lequel ledit générateur de matrice comprend :

un premier générateur de colonne pour générer une colonne de la matrice en évaluant les valeurs de l'une des fonctions localisées au niveau de la pluralité des positions ; et
un générateur de colonnes restantes pour générer les colonnes restantes de la matrice en appliquant des multiplicateurs exponentiels complexes aux éléments de la colonne.

12. Processeur de signal selon la revendication 3, dans lequel ledit inverseur de matrice comprend :

un premier générateur de colonne pour générer une colonne de la matrice de la transposée de conjugués de la transposée de conjugués inverses ; et
un générateur de colonnes de restantes pour générer les colonnes restantes de la matrice de la transposée de conjugués de la transposée de conjugués inverses en appliquant des multiplicateurs exponentiels complexes aux éléments de la colonne générée par ledit premier générateur de colonne.

13. Processeur de signal selon la revendication 2 ou 4, dans lequel les fonctions localisées sont sensiblement localisées dans un rectangle de surface $2\pi$ dans un espace espace-fréquence.

14. Processeur de signal selon la revendication 2 ou 4, dans lequel ledit générateur de matrice comprend :

un premier générateur de colonnes pour générer une colonne de la première matrice en évaluant les valeurs d'une première des fonctions localisées au niveau de la pluralité des positions, et pour générer une colonne de la deuxième matrice en évaluant les valeurs d'une seconde des fonctions localisées au niveau de la pluralité des positions ; et
un générateur de colonnes restantes pour générer les colonnes restantes de la première matrice en appliquant des multiplicateurs exponentiels complexes aux éléments de la colonne de la première matrice et pour générer les colonnes restantes de la deuxième matrice en appliquant des multiplicateurs exponentiels complexes aux éléments de la colonne de la deuxième matrice.

**15.** Processeur de signal selon la revendication 4, dans lequel ledit inverseur de matrice comprend :

un premier générateur de colonnes pour générer une colonne de la transposée de conjugués inverses de la première matrice et pour générer une colonne de la transposée de conjugués inverses de la deuxième matrice ; et un générateur de colonne restantes pour générer les colonnes restantes de la transposée de conjugués inverses de la première matrice en appliquant des multiplicateurs exponentiels complexes à des éléments de la colonne de transposée de conjugués inverses de la première matrice générée par ledit premier générateur de colonne, et pour générer le reste des colonnes de transposée de conjugués inverses de la deuxième matrice en appliquant des multiplicateurs exponentiels complexes aux éléments de la colonne de la transposée de conjugués inverses de la deuxième matrice générée par ledit premier générateur de colonne.

SIGNAL LENGTH, N
TIME SAMPLING INTERVALS, dt

**110**

**SCALE PARAMETERS GENERATOR**

- CALCULATE TIME SCALE, T
- CALCULATE FREQUENCY SCALE, Ω
- CONSTRUCT TIME N-VECTOR, $\underline{t}$

**120**

**FUNCTION SHAPES GENERATOR**

- DEFINE CENTERS AND SPREADS OF N LOCALIZED FUNCTIONS

**130**

**GABOR MATRIX GENERATOR**

- CONSTRUCT NxN GABOR MATRIX, G

**140**

**BASIS MATRIX GENERATOR**

- CALCULATE NxN BASIS MATRIX, F

**100**

# FIG. 1

T = N dt     ΔT = T / A     A B = N
Ω = π / dt     ΔΩ = 2Ω / B     ΔT ΔΩ = 2π
$t_m$ = m dt , for m = 0, ..., N
$t_C$ = (a - ½) ΔT, for a = 1, ..., A
$ω_C$ = (b - ½) ΔΩ, for b = 1-B, ..., B
For the simplified illustration above, A = 4, B = 6 and N = 24.

FIG. 2

EP 2 625 857 B1

FIG. 3

EP 2 625 857 B1

Nx1 INPUT SIGNAL, $\underline{s}$

410

420

**GABOR TRANSFORMER**

- CALCULATE THE Nx1 MODIFIED GABOR TRANSFORM, $\underline{c}$, OF THE INPUT SIGNAL

**SPARSE COMPRESSOR**

- COMPRESS $\underline{c}$ TO A SPARSE REPRESENTATION, CS

NxN GABOR MATRIX, G

**400**

FIG. 4

SPARSE REPRESENTATION, CS

⌒510    520 ⌒

<u>SPARSE DECOMPRESSOR</u>

- DECOMPRESS CS TO
AN Nx1 NON-SPARSE
REPRESENTATION, <u>c</u>

<u>INVERSE GABOR TRANSFORMER</u>

- RECONSTRUCT THE ORIGINAL
NX1 SIGNAL, <u>s</u>

<u>**500**</u>

NxN BASIS MATRIX, F

# FIG. 5

EP 2 625 857 B1

FIG. 6

IMAGE DIMENSIONS, N1xN2
SAMPLING INTERVALS, dx1 AND dx2

**SCALE PARAMETERS GENERATOR** — 710

- CALCULATE X1 AND X2 SCALES, TX1, TX2
- CALCULATE FREQUENCY SCALES, $\Omega 1$ AND $\Omega 1$
- CONSTRUCT N1-VECTOR, **x1**
- CONSTRUCT N2-VECTOR, **x2**

**FUNCTION SHAPES GENERATOR** — 720

- DEFINE CENTERS AND SPREADS
OF N1 LOCALIZED FUNCTIONS IN X1
- DEFINE CENTERS AND SPREADS
OF N2 LOCALIZED FUNCTIONS IN X2

**GABOR MATRICES GENERATOR** — 730

- CONSTRUCT N1xN1 GABOR MATRIX, G1
- CONSTRUCT N2xN2 GABOR MATRIX, G2

**BASIS MATRICES GENERATOR** — 740

- CALCULATE N1xN1 BASIS MATRIX, F1
- CALCULATE N2xN2 BASIS MATRIX, F2

**700**

FIG. 7

N1xN2 INPUT DIGITAL IMAGE, z

810

820

**TWO-DIMENSIONAL GABOR TRANSFORMER**

- CALCULATE THE N1xN2 TWO-DIMENSIONAL MODIFIED GABOR TRANSFORM, c, OF THE INPUT IMAGE

**SPARSE COMPRESSOR**

- COMPRESS c TO A SPARSE REPRESENTATION, CS

N1xN1 GABOR MATRIX, G1
N2xN2 GABOR MATRIX, G2

**800**

FIG. 8

EP 2 625 857 B1

SPARSE REPRESENTATION, CS

910

920

SPARSE DECOMPRESSOR

- DECOMPRESS CS TO
AN N1xN2 NON-SPARSE
REPRESENTATION, $\underline{c}$

TWO-DIMENSIONAL INVERSE
GABOR TRANSFORMER

- RECONSTRUCT THE ORIGINAL
N1XN2 DIGITAL IMAGE, $\underline{s}$

**900**

N1xN1 BASIS MATRIX, F1
N2xN2 BASIS MATRIX, F2

# FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TOURADJ EBRAHIMI et al.** Image Compression by Gabor expansion. *OPTICAL ENGINEERING, SOC. OF PHOTO-OPTICAL INSTRUMENTATION ENGINEERS,* 01 July 1991, vol. 30 (7), ISBN 0091-3286, 873-880
- A generalized non-separable 2-D discrete Gabor expansion for image representation and compression. **SHIDONG LI ED.** PROCEEDINGS OF THE INTERNATIONAL CONFERENCE ON IMAGE PROCESSING (ICIP) AUSTIN. INSTITUTE OF ELECTRICAL AND ELECTRONICS ENGINEERS, 13 November 1994
- PROCEEDINGS OF THE INTERNATIONAL CONFERENCE ON IMAGE PROCESSING (ICIP). IEEE COMP. SOC. PRESS, 13 November 1994, vol. 1, 810-814

- **GOURONC J-L et al.** A near optimal algorithm for image compression using Gabor expansion. *PROCEEDINGS OF THE INTERNATIONAL SYMPOSIUM ON CIRCUITS AND SYSTEMS. (ISCS),* 03 June 1993
- PROCEEDINGS OF THE INTERNATIONAL SYMPOSIUM ON CIRCUITS AND SYSTEMS. (ISCS). IEEE, 03 May 1993, 251-254
- COMPLETE GABOR TRANSFORMATION FOR SIGNAL REPRESENTATION. **YAO J.** IEEE TRANSACTIONS ON IMAGE PROCESSING. IEEE SERVICE CENTER, 01 April 1993, vol. 2, 152-159